# EUROPEAN PATENT APPLICATION

(11) **EP 3 125 167 A1**
(43) Date of publication of application: **01.02.2017**
(21) Application number: 16173670.7
(22) Date of filing: 09.06.2016
(51) Int. Cl.: G06Q 10/06, G06Q 10/00, G06Q 50/06

(54) **REMOTE MONITORING SYSTEM FOR MONITORING RENEWABLE ENERGY GENERATING APPARATUS**

(30) Priority: 28.07.2015 KR 20150106821
(71) Applicant: LSIS Co., Ltd., Gyeonggi-do 14119 (KR)
(72) Inventor: SHON, Sang-Ki, 14118 Gyeonggi-do (KR)
(74) Representative: Zacco Sweden AB

(57) **Abstract**

The present invention relates to a remote monitoring system for monitoring renewable energy generating apparatuses and, more particularly, to a remote monitoring system for monitoring renewable energy generating apparatuses, the remote monitoring system including a plurality of energy generating apparatuses (100) for generating energy using a renewable energy source, and a monitoring server (200) for receiving output amount information from each of the energy generating apparatuses and determine a condition of each of the energy generating apparatuses by comparing the received output amount information with output amount information about a previously used energy generating apparatus.

The present invention receives output amount information from multiple renewable energy generating apparatuses configured to generate energy using sunlight, wind power or hydraulic power, and determines the conditions of the renewable energy generating apparatuses in use using the output amount information. Accordingly, the need for installation of separate sensors is eliminated. Therefore, the overall structure of the energy generating apparatuses is simplified, and installation cost may be greatly reduced.

## Description

### BACKGROUND

### 1. Technical Field

The present invention relates to a remote monitoring system for monitoring renewable energy generating apparatuses and, more particularly, to a remote monitoring system for monitoring renewable energy generating apparatuses which allows the condition of renewable energy generating apparatuses in use to be checked using information about the renewable energy generating apparatuses which are of a type similar to the type of a previously used renewable energy generating apparatus or are used in an environment similar to the environment of the previously used renewable energy generating apparatus.

### 2. Description of the Related Art

According to a dictionary definition, renewable energy refers to naturally created energy such as solar heat, sunlight, wind, tide and geothermal heat. In terms of technology, renewable energy covers a wide variety of energy including solar energy, wind power, hydraulic power, and biofuels. The importance of renewable energy has been increasingly emphasized as the problem of climate change is deepened and fossil fuels are depleted.

To generate electricity using renewable energy, apparatuses such as, for example, a solar power generation apparatus and a solar heat utilization apparatus have been proposed. The solar power generation apparatus converts sunlight into electric energy through a solar panel formed by arranging multiple solar cells on a panel having a certain thickness, and the solar heat utilization apparatus collects heat from sunlight using a heat collecting sphere formed at the center of a concave reflective panel. In addition, a hydraulic generation apparatus and a wind power generation apparatus have been proposed to generate electricity using renewable energy. The hydraulic generation apparatus converts hydraulic power into electric energy by driving a generator when a turbine is rotated by falling water, and the wind power generation apparatus converts wind energy into electric energy by driving a generator when a turbine is rotated by wind. Further, a geothermal heat generation apparatus and a hydrogen generation apparatus have been proposed to generate electricity using renewable energy. The geothermal heat generation apparatus converts geothermal heat into electric energy by driving a generator when a turbine is rotated by produced vapor, and the hydrogen generation apparatus generates electric energy using reaction between hydrogen and oxygen.

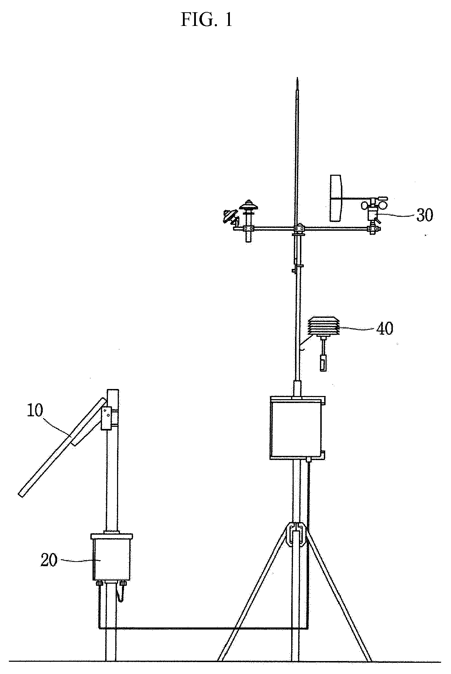

Fig. 1 illustrates configuration of a conventional meteorological observation apparatus for observing sunlight and wind which are used as renewable energy. As shown in Fig. 1, the meteorological observation apparatus includes a solar cell 10, a battery 20, an anemometer 30 and a thermometer 40.

The conventional meteorological observation apparatus, which is a renewable energy system using wind speed and the like, is provided with various kinds of sensors and determines the service life and malfunction of the renewable energy system using information obtained through the sensors. Due to such configuration, the conventional renewable energy system has a complex structure and it is difficult to implement integrated management of multiple systems.

Moreover, as multiple sensors are provided for the system, installation of the system is very expensive.

### BRIEF SUMMARY

It is an aspect of the present invention to provide a remote monitoring system for monitoring renewable energy generating apparatuses which allows the condition of renewable energy generating apparatuses in use to be checked using information about the renewable energy generating apparatuses which are of a type similar to the type of a previously used renewable energy generating apparatus or are used in an environment similar to the environment of the previously used renewable energy generating apparatus.

In accordance with one aspect of the present invention, a remote monitoring system for monitoring renewable energy generating apparatuses includes a plurality of energy generating apparatuses for generating energy using a renewable energy source, and a monitoring server for receiving output amount information from each of the energy generating apparatuses and determine a condition of each of the energy generating apparatuses by comparing the received output amount information with output amount information about a previously used energy generating apparatus.

In accordance with another aspect of the present invention, a remote monitoring system for monitoring renewable energy generating apparatuses using output amount information about the renewable energy generating apparatuses, the remote monitoring system includes a plurality of energy generating apparatuses for generating energy using a renewable energy source, and a monitoring server including a receiver for receiving output amount information from each of the energy generating apparatuses, a storage unit for storing the output amount information about the respective energy generating apparatuses and a previously used energy generating apparatus, and a determination unit for determining an expected service life, malfunction or necessity of repair of each of the energy generating apparatuses by comparing the output amount information received through the receiver with output amount information pre-stored in the storage unit.

The pre-stored output amount information about the energy generating apparatuses may include change in an output amount according to a period of use of the energy generating apparatuses, change in the output amount according to a condition of use, and change in the output amount according to duration of use.

The determination unit compares the pre-stored output amount information about the energy generating apparatuses with the output amount information about the energy generating apparatus in use, wherein, when an output amount of the energy generating apparatus in use is smaller than half a pre-stored output amount of the energy generating apparatus under the same condition, malfunction may be determined, wherein, when the output amount of the energy generating apparatus in use is larger than or equal to half the pre-stored output amount of the energy generating apparatus and smaller than two thirds of the pre-stored output amount the under same condition, repair may be determined, wherein, when the output amount of the energy generating apparatus in use is larger than two thirds of the pre-stored output amount, abnormality may be determined.

The determination unit may receive the output amount information about the energy generating apparatuses in use and compare change in the output amount over time with pre-stored change in the output amount over time to determine the expected service life of each of the energy generating apparatuses.

The determination unit may determine abnormality, malfunction or necessity of repair of the energy generating apparatuses in use by comparing the output amount information about the energy generating apparatuses with pre-stored output amount information about the energy generating apparatuses, and transmit determined information to the user through a text message.

The remote monitoring system may further include an interface for providing information determined by the monitoring server according to manipulation of a user.

The interface may provide a malfunction determination item indicating whether each of the energy generating apparatuses in use corresponds to one of abnormality, malfunction and repair, change in the output amount of time, an expected service life according to change in the output amount, and an output amount curve.

Each of the energy generating apparatuses and the previously used energy generating apparatus may be of the same type.

Each of the energy generating apparatuses and the previously used energy generating apparatus may have the same product information or environment information.

Each of the energy generating apparatuses and the previously used energy generating apparatus may have at least one of the same manufacturing date and the same installation date as the product information.

Each of the energy generating apparatuses and the previously used energy generating apparatus may have at least one of the same solar radiation, the same precipitation, the same wind volume and the same wind speed as the environment information.

As described above, a remote monitoring system for monitoring renewable energy generating apparatuses according to the present invention receives output amount information from multiple renewable energy generating apparatuses configured to generate energy using sunlight, wind power or hydraulic power, and determines the conditions of the renewable energy generating apparatuses in use using the output amount information. Accordingly, the need for installation of separate sensors is eliminated. Therefore, the overall structure of the energy generating apparatuses is simplified, and installation cost may be greatly reduced.

In addition, the received output amount information about the renewable energy generating apparatuses in use is compared with the output amount information about a renewable energy generating apparatus which is of a similar type or used in a similar environment. Thereby, the conditions of the renewable energy generating apparatuses may be easily recognized without separately checking the conditions.

Further, as information about an energy generating apparatus in use is provided in the form of an output amount curve through an interface, the current condition of the monitored energy generating apparatus may be accurately determined.

### BRIEF DESCRIPTION OF THE DRAWINGS

Fig. 1 illustrates configuration of a conventional meteorological observation apparatus for observing sunlight and wind which are used as renewable energy.
Fig. 2 is a diagram illustrating configuration of a remote monitoring system according to an embodiment of the present invention.
Fig. 3 is a block diagram illustrating a monitoring server of the remote monitoring system according to the embodiment of the present invention.
Fig. 4 is a diagram illustrating configuration of the screen of an interface constituting the remote monitoring system according to the embodiment of the present invention.

### DETAILED DESCRIPTION

Hereinafter, embodiments of the present invention will be described in detail with reference to the accompanying drawings. It should be understood that the present invention is not limited to the following embodiments, and that the embodiments are provided for illustrative purposes only. The scope of the invention should be defined only by the accompanying claims and equivalents thereof.

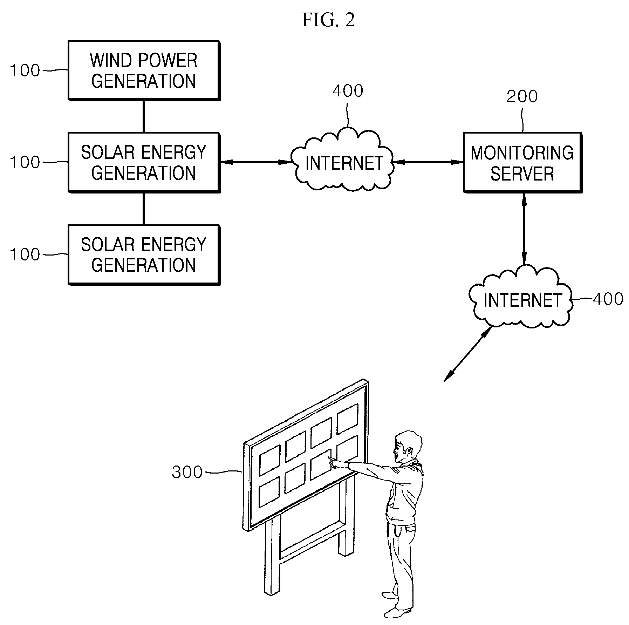

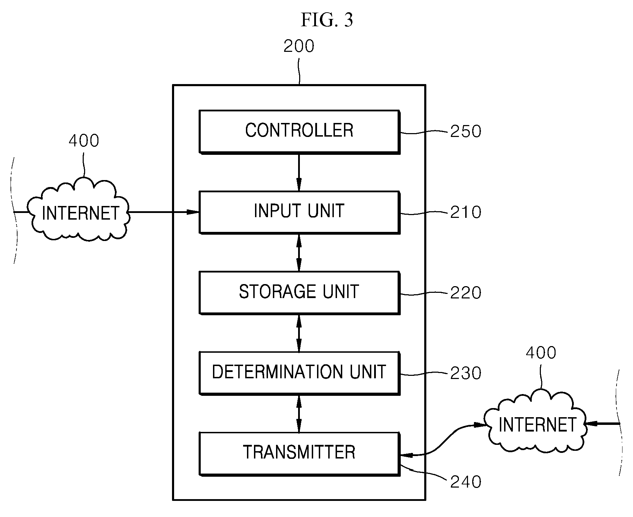

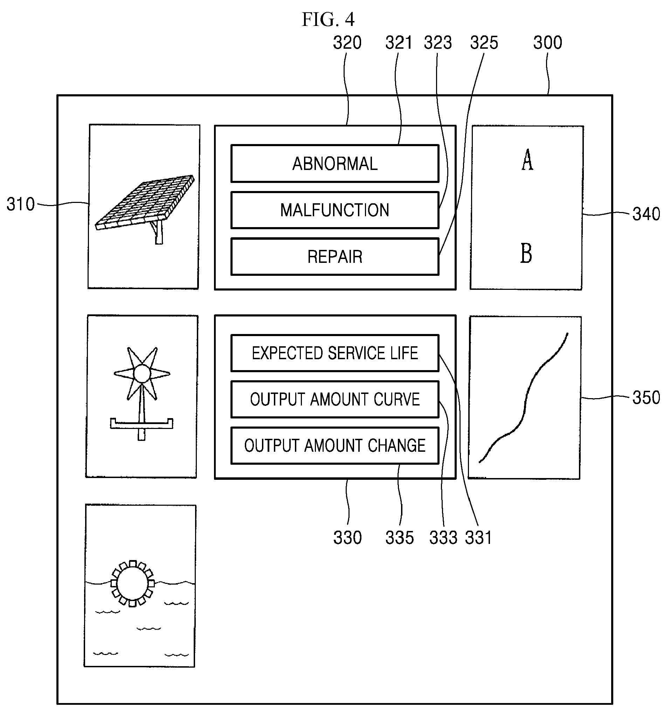

Fig. 2 is a diagram illustrating configuration of a remote monitoring system according to an embodiment of the present invention. Fig. 3 is a block diagram illustrating a monitoring server of the remote monitoring system according to the embodiment of the present invention. Fig. 4 is a diagram illustrating configuration of the screen of an interface constituting the remote monitoring system according to the embodiment of the present invention.

As shown in Fig. 2, a remote monitoring system for monitoring renewable energy generating apparatuses according to an embodiment of the present invention includes an energy generating apparatus 100, a monitoring server 200, and an interface 300. The energy generating apparatus 100, the monitoring server 200 and the interface 300 are connected to each other via the Internet 400, using cloud computing technology.

The cloud computing technology refers to a user-oriented computer environment where an operation desired by a user can be performed. More specifically, according to the cloud computing technology, information about a program or document individually stored in a personal computer or a server of a company is stored in a large-scale computer which is accessible via the Internet. The cloud computing technology enables various terminals including personal computers and mobile devices to perform a desired operation by executing a necessary application such as a web browser.

Accordingly, in the present invention, information about the energy generating apparatuses 100 may be stored in the monitoring server 200, and the information stored in the monitoring server 200 may be used in a personal computer via the Internet 400.

Among the constituents connected to each other through the cloud computing technology, the energy generating apparatuses 100 are configured to generate energy from solar energy, wind energy or hydraulic energy. In addition, the energy generating apparatuses 100 produce energy using a solar cell, a windmill, or a hydraulic power generator.

The monitoring server 200 receives output amount information generated from each energy generating apparatus 100. Thereafter, the monitoring server 200 compares the received output amount information with output amount information about an energy generating apparatus 100 which is of the same type or used in the same environment as each pre-stored energy generating apparatus (not shown). The monitoring server 200 diagnoses the current condition of each energy generating apparatus 100 using the result of comparison.

Herein, the same type may represent solar energy, hydraulic energy or wind energy.

In addition, the same environment may correspond to the same production area or complex as that of each energy generating apparatus 100. In addition, the same environment may correspond to a case where each energy generating apparatus 100 has the same product information and environment information as those of a pre-stored energy generating apparatus.

Herein, the product information corresponds to the manufacturing date and installation date, and the environment information corresponds to solar radiation, precipitation, wind volume and wind speed.

Accordingly, the monitoring server 200 diagnoses the current condition of each energy generating apparatus 100 by comparing the output amount of the energy generating apparatus 100 with the output amount of a pre-stored energy generating apparatus which has the same product information or environment information as the energy generating apparatus 100 among the pre-store the energy generating apparatuses.

The interface 300 may include a personal computer or a smartphone terminal, and provides various kinds of information through the screen thereof such that the conditions of the energy generating apparatuses 100 can be checked.

As shown in Fig. 3, the monitoring server 200 includes a receiver 210, a storage unit 220, a determination unit 230, a transmitter 240 and a controller 250.

The receiver 210 receives the output amount information generated from each of the energy generating apparatuses 100.

The storage unit 220 stores output amount information about a previous energy generating apparatus which is of a type similar to each of the energy generating apparatuses or used in an environment (area or complex) similar to the environment for the energy generating apparatuses 100.

The determination unit 230 compares the output amount information received through the receiver 210 with the output amount information pre-stored in the storage unit 220 to determine the expected service life, expected production, malfunction, or necessity of repair of each energy generating apparatus 100.

Herein, the pre-stored output amount information about the energy generating apparatus includes change in output amount according to the period of use of the energy generating apparatus 100, change in the output amount according to usage conditions, and change in the output amount according to duration of use.

However, the output amount information is not limited thereto. Various kinds of information may be pre-stored and used such that the conditions of the energy generating apparatuses 100 can be checked.

For example, information about whether the output amount is maintained constantly over time and whether a large output amount is generated in a certain unit may be stored and used.

The transmitter 240 transmits the information determined through the determination unit 230 to the interface 300, and the controller 250 controls operation of each constituent.

Herein, the determination unit 230 compares the pre-stored output amount information about the energy generating apparatus with the output amount information about the energy generating apparatus 100 in use to diagnose the condition of the energy generating apparatus 100.

That is, if the output amount of the energy generating apparatus in use is smaller than half the pre-stored output amount of the energy generating apparatus, it is determined that the energy generating apparatus malfunctions. If the output amount of the energy generating apparatus in use is larger than or equal to half the pre-stored output amount of the energy generating apparatus and smaller than two thirds of the pre-stored output amount of the energy generating apparatus, it is determined that the energy generating apparatus needs to be repaired. If the output amount of the energy generating apparatus in use is larger than two thirds of the pre-stored output amount, it is determined that the energy generating apparatus is abnormal. In this way, the condition of the energy generating apparatus 100 is diagnosed.

In addition, the determination unit 230 receives the output amount information about the energy generating apparatus 110 and compares change in the output amount over time with pre-stored change in the output amount of the energy generating apparatus over time. Thereafter, the determination unit 230 determines the expected service life of the energy generating apparatus 100 in use based on the result of comparison

That is, by comparing the change rate of the output amount of the energy generating apparatus 100 in use with the change rate of the output amount of a previously used energy generating apparatus, the expected service life of the energy generating apparatus 100 in use may be determined. If the change rate of the output amount of the energy generating apparatus 100 in use is half the change rate of the output amount of a pre-stored energy generating apparatus of a similar type, it may be determined that the service life of the energy generating apparatus 100 in use is half the service life of the pre-stored energy generating apparatus of a similar type.

In addition, once the determination unit 230 determines abnormality, malfunction or necessity of repair by comparing the output amount information about the energy generating apparatus 100 in use with the pre-stored output amount information about the energy generating apparatus 100, the determination unit 230 may transmit the determined information to a personal computer, smartphone terminal or personal portable device of the user through a text message.

As shown in Fig. 4, database 300 may provide the user with various kinds of information for the user in various forms, and the user may easily check the condition of the energy generating apparatus 100 in use through the provided information.

More specifically, an energy generating apparatus indication item 310 showing the shape of the energy generating apparatus 100, a malfunction determination item 320 indicating whether each energy generating apparatus 100 in use corresponds to Abnormal 321, Malfunction 323 or Repair 325, and an expected service life item 330 including Output Amount Change 335 over time, Output Amount Curve 333 according to change in the output amount and Expected Service Life 331 are provided through the screen of the interface 300.

In addition, a display window 340 for providing the serial number of the energy generating apparatus 100 corresponding to an item selected in the malfunction determination item 320 and a display window 350 for displaying an output amount curve and change in the output amount over time are provided

Accordingly, when the user selects Repair 325 in the malfunction determination item 320, the serial number of an energy generating apparatus 100 which needs to be repaired is provided on the display window 340 through the screen. If there is no apparatus corresponding to the selection, nothing is displayed.

In addition, if the Output Amount Curve 333 is selected, the Output Amount Curve 333 is displayed on the display window 350. In this case, the output amount curve (not shown) of an energy generating apparatus of a similar type and the Output Amount Curve 333 of the energy generating apparatus 100 in use may all be provided through the screen. In addition, if the Output Amount Curve 333 is selected, the Expected Service Life 331 may be provided through the Output Amount Curve 333 in the display window 350.

According to another embodiment, the determination unit 230 may transmit the serial number of the energy generating apparatus 100 that needs to be repaired to the personal computer, smartphone terminal or personal portable device of the user through a text message.

In addition, the determination unit 230 may generate images of the output amount curves of the energy generating apparatus 100 in use and an energy generating apparatus of a type similar to that of the energy generating apparatus 100 and transmit the same to the personal computer, smartphone terminal or personal portable device of the user.

With the present invention configured as described above, output amount information may be received from multiple renewable energy generating apparatuses 100 in use, and the conditions of the renewable energy generating apparatuses 100 in use may be checked using the output amount information. Accordingly, the overall structure of the energy generating apparatuses 100 may be simplified and installation cost may be reduced as need for installation of separate sensors is eliminated.

In addition, as the output amount information about a renewable energy generating apparatus 100 in use is received and compared with the output amount information about a renewable energy generating apparatus 100 which is of a similar type or used in a similar environment, the condition of the renewable energy generating apparatus 100 may be easily recognized without separate checking of the condition of the renewable energy generating apparatus 100.

Further, as the information about the energy generating apparatus 100 in use is provided in various forms such as the output amount curve 333 through the interface 300, the current condition of the energy generating apparatus 100 which is being monitored may be accurately determined.

Although exemplary embodiments have been described above for illustrative purposes, it will be apparent to those skilled in the art that various modifications and variations can be made in the present invention without departing from the spirit or scope of the invention. The description given above is intended to limit the scope of the present invention. The scope of the present invention should be determined by the appended claims and their equivalents.

## Claims

1. A remote monitoring system for monitoring renewable energy generating apparatuses using output amount information about the renewable energy generating apparatuses, the remote monitoring system comprising:
a plurality of energy generating apparatuses (100) for generating energy using a renewable energy source;
a monitoring server (200) comprising a receiver (210) for receiving output amount information from each of the energy generating apparatuses (100), a storage unit (220) for storing the output amount information about the respective energy generating apparatuses and a previously used energy generating apparatus, and a determination unit (230) for determining an expected service life, malfunction or necessity of repair of each of the energy generating apparatuses by comparing the output amount information received through the receiver with output amount information pre-stored in the storage unit; and
an interface (300) for providing information determined by the monitoring server according to manipulation of a user.

2. The remote monitoring system according to claim 1, wherein the pre-stored output amount information about the energy generating apparatuses includes change in an output amount according to a period of use of the energy generating apparatuses (100), change in the output amount according to a condition of use, and change in the output amount according to duration of use.

3. The remote monitoring system according to claim 2, wherein the determination unit (230) compares the pre-stored output amount information about the energy generating apparatuses with the output amount information about the energy generating apparatus (100) in use,
wherein, when an output amount of the energy generating apparatus (100) in use is smaller than half a pre-stored output amount of the energy generating apparatus under the same condition, malfunction is determined,
wherein, when the output amount of the energy generating apparatus (100) in use is larger than or equal to half the pre-stored output amount of the energy generating apparatus and smaller than two thirds of the pre-stored output amount the under same condition, repair is determined,
wherein, when the output amount of the energy generating apparatus (100) in use is larger than two thirds of the pre-stored output amount, abnormality is determined.

4. The remote monitoring system according to claim 2, wherein the determination unit (230) receives the output amount information about the energy generating apparatuses (100) in use and compares change in the output amount over time with pre-stored change in the output amount over time to determine the expected service life of each of the energy generating apparatuses (100).

5. The remote monitoring system according to claim 2, wherein the determination unit (230) determines abnormality, malfunction or necessity of repair of the energy generating apparatuses (100) in use by comparing the output amount information about the energy generating apparatuses (100) with pre-stored output amount information about the energy generating apparatuses, and transmits determined information to the user through a text message.

6. The remote monitoring system according to claim 1, wherein the interface (300) provides a malfunction determination item indicating whether each of the energy generating apparatuses in use corresponds to one of abnormality, malfunction and repair, change in the output amount of time, an expected service life according to change in the output amount, and an output amount curve.

7. The remote monitoring system according to claim 1, wherein each of the energy generating apparatuses (100) and the previously used energy generating apparatus are of the same type.

8. The remote monitoring system according to claim 1, wherein each of the energy generating apparatuses (100) and the previously used energy generating apparatus have the same product information or environment information.

9. The remote monitoring system according to claim 8, wherein each of the energy generating apparatuses (100) and the previously used energy generating apparatus have at least one of the same manufacturing date and the same installation date as the product information.

10. The remote monitoring system according to claim 8, wherein each of the energy generating apparatuses (100) and the previously used energy generating apparatus have at least one of the same solar radiation, the same precipitation, the same wind volume and the same wind speed as the environment information.
